# FASCICULE DE BREVET EUROPEEN

(11) **EP 3 583 699 B1**
(45) Date de publication et mention de la délivrance du brevet: **28.08.2024**
(21) Numéro de dépôt: 18703052.3
(22) Date de dépôt: 11.01.2018
(51) Int. Cl.: H03K 19/017, H03K 19/0948

(54) **CIRCUIT DE POLARISATION ACTIVE ET FAIBLE CONSOMMATION D'UNE ENTRÉE HAUTE IMPÉDANCE**
AKTIVE POLARISATIONS- UND KLEINVERBRAUCHSSCHALTUNG FÜR EINEN HOCHIMPEDANZSEINGANG
ACTIVE POLARISATION AND LOW CONSUMPTION CIRCUIT FOR A HIGH IMPEDANCE INPUT

(30) Priorité: 16.02.2017 FR 1751267
(43) Date de publication de la demande: 25.12.2019
(73) Titulaire: Spryngs, 38000 Grenoble (FR)
(72) Inventeur: DELORME, Nicolas, Pierre, 38000 Grenoble (FR); LE BLANC, Christophe, 38000 Grenoble (FR); SAIAS, Daniel, 38000 Grenoble (FR)
(74) Mandataire: de Jong, Jean Jacques
(86) Numéro de dépôt international: PCT/FR2018/050063
(87) Numéro de publication internationale: WO 2018/150111

(56) Documents cités:
- EP-A1- 0 583 203
- EP-A2- 0 600 816
- EP-A2- 0 762 648
- WO-A2-03/088289
- US-A- 4 813 020
- US-A- 5 490 110

## Description

### Domaine technique

La présente demande de brevet est relative à l'acquisition de signaux fournis par des capteurs, signaux pouvant basculer entre un état de basse impédance et un état de haute impédance. Dans certaines situations on cherche plus particulièrement à reconnaître l'état de haute impédance comme un état logique défini.

### Arrière-plan

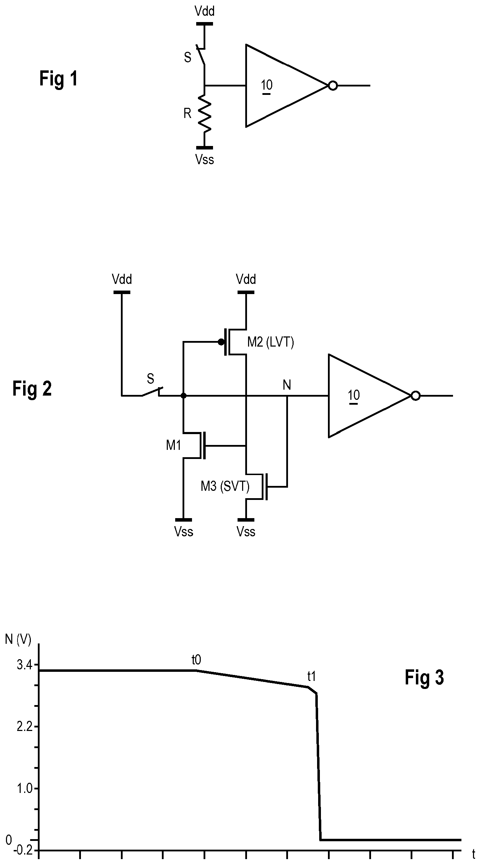

Dans la figure 1 un capteur fournissant un signal à mesurer est un interrupteur S. On cherche à savoir si l'interrupteur est ouvert ou fermé. L'interrupteur S est relié entre une ligne d'alimentation haute Vdd et une entrée d'un circuit de traitement numérique, généralement une porte logique, illustrée par un inverseur 10.

Si l'interrupteur S est fermé, l'entrée de l'inverseur 10 est reliée à la ligne Vdd par un chemin basse impédance qui détermine l'état « 1 » sans ambiguïté.

Si l'interrupteur S est ouvert, celui-ci présente une haute impédance, de sorte que, en l'absence d'autres mesures, l'entrée de l'inverseur est flottante et n'a pas d'état défini. Pour éviter cela, on prévoit généralement une polarisation de l'entrée de l'inverseur à la ligne d'alimentation basse Vss par une impédance de rappel R.

La présence d'une impédance de rappel produit inévitablement une consommation de courant statique lorsque l'interrupteur S est fermé. La valeur de l'impédance R, de préférence aussi élevée que possible, est toutefois choisie suffisamment basse pour que la décharge du noeud d'entrée de l'inverseur vers la ligne Vss se produise à une vitesse satisfaisante. Dans des applications basse-consommation, de tels courants statiques ne sont pas souhaités.

Pour diminuer la consommation statique dans le contexte de l'exploitation d'un signal à trois états (« 0 », « 1 », et « Hi-Z » ou haute impédance) le brevet US6133753 propose de mesurer l'état d'un noeud d'entrée par intermittence. Ainsi, le circuit ne consomme du courant que pendant les phases de mesure. Cependant, une mesure par intermittence n'est pas adaptée à la mesure d'événements brefs qui pourraient survenir entre deux phases de mesure.

EP 0 583 203 A1 divulgue un circuit de tirage vers un état déterminé d'une entrée de circuit intégré.

### Résumé

La présente demande de brevet prévoit de façon générale un circuit de détection d'un état flottant d'un noeud, tel que revendiqué dans la revendication indépendante 1.

Les premier et deuxième transistors peuvent avoir une tension seuil plus basse que le troisième transistor.

Le circuit peut comprendre un commutateur mécanique relié entre le noeud et la deuxième ligne d'alimentation.

Le noeud peut être relié à une entrée d'un circuit de traitement.

On prévoit également un procédé de détection d'un état flottant d'un noeud, tel que revendiqué dans la revendication indépendante 5.

### Description sommaire des dessins

Des modes de réalisation seront exposés dans la description suivante, faite à titre non limitatif en relation avec les figures jointes parmi lesquelles :
- la figure 1, précédemment décrite, illustre schématiquement un circuit de mesure classique de l'état d'un interrupteur ;
- la figure 2 illustre un mode de réalisation d'un circuit de détection d'un état flottant d'un noeud, présentant une faible consommation statique ; et
- la figure 3 est un graphe illustrant un exemple d'évolution du potentiel d'un noeud commuté d'un état polarisé vers un état flottant, en utilisant le circuit de la figure 2.

### Description de modes de réalisation

La figure 2 représente schématiquement un mode de réalisation d'un circuit conçu pour établir un niveau logique déterminé sur un noeud flottant N, et cela sans utiliser de courant de polarisation, même par intermittence.

Le circuit est représenté dans une configuration pour détecter l'état d'un interrupteur S relié à une ligne d'alimentation haute Vdd, comme à la figure 1. Le potentiel Vdd peut représenter le niveau logique « 1 », niveau qui est transmis sans ambiguïté au noeud N lorsque l'interrupteur S est fermé. Le niveau logique « 0 » serait alors représenté par le potentiel d'une ligne d'alimentation basse Vss.

Dans cette configuration, on souhaite que le niveau sur le noeud N soit perçu comme un « 0 » par la porte 10 lorsque l'interrupteur S est ouvert. Pour cela, le circuit de la figure 2 est configuré pour forcer le noeud N au potentiel bas Vss lorsque le noeud devient flottant.

Plus spécifiquement, le mode de réalisation de la figure 2 comprend deux transistors MOS complémentaires M1 et M2 connectés pour former un verrou qui s'enclenche à l'abaissement du potentiel du noeud N pour confirmer l'état bas (Vss) de ce noeud. Le transistor M1, à canal N, a sa source reliée à la ligne Vss et son drain relié au noeud N. Le transistor M2, à canal P, a sa source reliée à la ligne Vdd, sa grille reliée au noeud N, et son drain relié à la grille du transistor M 1.

Cette configuration permet de détecter l'ouverture de l'interrupteur S, c'est-à-dire le passage à l'état flottant du noeud N. L'interrupteur S étant initialement fermé, le noeud N est au potentiel Vdd. Le transistor M2 est bloqué, sa tension grille-source étant nulle. On suppose que le transistor M1 est également bloqué, ce qui peut être obtenu en polarisant la grille du transistor M1 au potentiel Vss par un transistor M3.

Le rôle spécifique du transistor M3 tel que représenté sera décrit ultérieurement - on suppose pour l'instant qu'il agit seulement comme une source de courant constant servant à polariser la grille du transistor M1.

Dans cette configuration, les transistors M1 et M2 étant bloqués, le circuit ne consomme aucun courant statique engendré par une polarisation. Seuls subsistent le courant de fuite du transistor M1 à travers l'interrupteur fermé S et le courant de fuite du transistor M2 à travers le transistor M3. Un courant de fuite de transistor est généralement plusieurs ordres de grandeur plus faible qu'un courant de polarisation.

La figure 3 est un graphe illustrant un exemple d'évolution du potentiel du noeud N survenant lors d'une ouverture de l'interrupteur S.

Lorsque l'interrupteur S est ouvert à un instant t0, le noeud N devient flottant, en supposant que le circuit de traitement 10 est à base de transistors MOS, par exemple en technologie CMOS. Le potentiel du noeud N est maintenu temporairement par les capacités parasites des éléments connectés au noeud, notamment la capacité de grille du transistor M2 et des transistors formant l'entrée de la porte logique 10. Cependant, malgré que le transistor M1 soit à l'état bloqué, il présente un courant de fuite inévitable, comme on l'a précédemment évoqué. Il en résulte que le potentiel du noeud N se met à décroître lentement vers le potentiel bas Vss, comme cela est illustré entre l'instant t0 et un instant t1.

À l'instant t1, la différence entre le potentiel du noeud N et le potentiel haut Vdd atteint le seuil du transistor M2. Le transistor M2 se met à conduire et élève le potentiel sur la grille du transistor M1. Le transistor M1 se met à conduire à son tour et tire le noeud N plus rapidement vers le potentiel Vss. Les transistors M1 et M2 confirment mutuellement leurs états conducteurs et assument un état verrouillé. Le noeud N produit alors un niveau logique « 0 » stable et à basse impédance.

Lorsque l'interrupteur S est de nouveau fermé, celui-ci tire le noeud N vers le potentiel Vdd malgré l'effet antagoniste du transistor M1. Le transistor M1, étant généralement un transistor de plus petite taille du noeud technologique utilisé, présente une impédance à l'état conducteur notablement plus élevée qu'un interrupteur fermé. Lorsque le potentiel du noeud N se rapproche suffisamment du potentiel Vdd, le transistor M2 se bloque et n'alimente plus la grille du transistor M1. La grille du transistor M1 est tirée vers le potentiel bas Vss par le transistor M3, provoquant le blocage du transistor M1.

Dans la configuration où le noeud N est au niveau « 0 », à savoir où les transistors M1 et M2 sont verrouillés à l'état conducteur, si le transistor M3 était une simple source de courant, le circuit consommerait un courant statique à travers les transistors M2 et M3.

Pour supprimer cette consommation de courant, la grille du transistor M3, un transistor à canal N, est en fait reliée au noeud N, comme cela est représenté. Cette configuration produit plusieurs effets.

Lorsque le noeud N est au niveau « 0 » et que les transistors M1 et M2 sont conducteurs, le transistor M3 est bloqué, supprimant le courant de polarisation qui pouvait circuler entre le transistor M2 et la ligne Vss. Le circuit ne consomme alors aucun courant de polarisation.

Par ailleurs, à la fermeture de l'interrupteur S, le transistor M3 est rendu conducteur relativement tôt au cours de l'élévation du potentiel du noeud N vers le potentiel Vdd, provoquant le blocage précoce du transistor M1 et limitant le pic de courant circulant par l'interrupteur et le transistor M1.

À partir de l'instant t1 après l'ouverture de l'interrupteur S, quand le transistor M2 devient conducteur, il peut subsister une phase de conduction simultanée des transistors M2 et M3, le transistor M3 étant bloqué plus tard au cours de l'abaissement du potentiel du noeud N. Le transistor M2 peut être conçu plus grand que le transistor M3, de sorte qu'il tire la grille du transistor M1 plus vite vers le potentiel Vdd malgré l'antagonisme du transistor M3.

Une phase de conduction simultanée des transistors M2 et M3 survient également à la fermeture de l'interrupteur S, lorsque le potentiel du noeud N s'élève vers le potentiel Vdd, dans une plage où les seuils des transistors M2 et M3 sont dépassés simultanément. Si on voulait éviter une conduction simultanée, il faudrait que la somme des seuils des transistors M2 et M3 soit supérieure ou égale à la tension d'alimentation Vdd.

Selon un mode de réalisation, le transistors M2 peut être de type dit LVT (« Low-Vt » ou basse tension seuil), tandis que le transistor M3 est de type SVT (« Standard-Vt » ou tension seuil normale).

Alors, à l'ouverture de l'interrupteur S, le transistor M2 devient conducteur plus tôt au cours l'abaissement du potentiel du noeud N vers le potentiel Vss, raccourcissant ainsi l'intervalle t0-t1.

Cela augmente cependant la phase de conduction simultanée des transistors M2 et M3, augmentation qui est partiellement compensée par le fait que le transistor M3 conserve un seuil normal (SVT).

Le transistor M1 peut être type LVT ou SVT. S'il est de type LVT, il présentera un courant de fuite légèrement plus élevé à l'état bloqué, contribuant également à raccourcir l'intervalle t0-tl sans augmenter de façon sensible la consommation statique du circuit.

Le graphe de la figure 3 correspond à un exemple de transistors élémentaires dans une technologie CMOS de 180 nm. Les seuils LVT et SVT sont alors de 0,4 V et 0,6 V. Les graduations temporelles du graphe correspondent à 5 ns. Le pic de courant provoqué à la fermeture de l'interrupteur S atteint environ 350 µA sur une durée d'environ 2 ns, ce pic incluant la conduction simultanée des transistors M2 et M3. Le pic de courant provoqué par la conduction simultanée des transistors M2 et M3 à l'ouverture de l'interrupteur atteint environ 14 µA sur une durée d'environ 1 ns.

Selon un autre mode de réalisation, si on souhaite diminuer le pic de courant provoqué à la fermeture de l'interrupteur S, on peut diminuer le seuil du transistor M3 et augmenter le seuil du transistor M2, c'est-à-dire intervertir les types LVT et SVT de ces transistors. Dans ce cas, à la fermeture de l'interrupteur S, la mise en conduction du transistor M3 est plus précoce, provoquant un blocage plus précoce du transistor M1. La phase de conduction simultanée des transistors M2 et M3 reste inchangée, puisque la somme des tensions seuils des transistors M2 et M3 est conservée.

De nombreuses variantes et modifications des modes de réalisation décrits ici apparaîtront à l'homme du métier. Les modes de réalisation décrits visent à détecter l'état d'un interrupteur relié à un potentiel d'alimentation haut Vdd. Une configuration duale peut être prévue pour détecter l'état d'un interrupteur relié au potentiel d'alimentation bas Vss, obtenue en intervertissant les types de conductivité des transistors et les lignes d'alimentation.

## Revendications

1. Circuit de détection d'un état flottant d'un noeud, comprenant :
• un noeud (N) connecté pour, en fonctionnement, avoir deux états de travail, à savoir un état basse impédance où il est relié à une première ligne d'alimentation (Vdd) par un chemin basse impédance (S), et un état flottant où aucun élément ne fixe son potentiel ;
• un premier transistor MOS (M1) de premier type de conductivité relié entre le noeud (N) et une deuxième ligne d'alimentation (Vss) ; et
• un deuxième transistor MOS (M2) de type de conductivité complémentaire au premier type de conductivité, commandé par le noeud (N) et relié entre la grille du premier transistor (M1) et la première ligne d'alimentation (Vdd);
**caractérisé en ce qu'**il comprend un troisième transistor MOS (M3) du premier type de conductivité commandé par le noeud (N) et relié entre la grille du premier transistor (M1) et la deuxième ligne d'alimentation (Vss).

2. Circuit selon la revendication 1, dans lequel les premier et deuxième transistors ont une tension seuil (LVT) plus basse que le troisième transistor.

3. Circuit selon la revendication 1, comprenant un commutateur mécanique (S) relié entre le noeud (N) et la première ligne d'alimentation (Vdd).

4. Circuit selon la revendication 3, dans lequel le noeud (N) est relié à une entrée d'un circuit de traitement (10).

5. Procédé de détection d'un état flottant d'un noeud, comprenant les étapes suivantes :
• relier le noeud (N) à un premier potentiel (Vdd) par un chemin basse impédance (S) ;
• couper le chemin basse impédance pour placer le noeud dans un état flottant où aucun élément ne fixe son potentiel ;
• décharger le noeud vers un deuxième potentiel (Vss) par un courant de fuite d'un premier transistor MOS (M1) à l'état bloqué ; et
• lorsque l'écart entre le potentiel du noeud et le premier potentiel (Vdd) atteint un seuil d'un deuxième transistor MOS (M2), rendre conducteur le premier transistor MOS.
**caractérisé en ce qu'**il comprend les étapes suivantes :
• le noeud (N) étant initialement au deuxième potentiel (Vss), tirer le noeud vers le premier potentiel (Vdd) par la fermeture d'un interrupteur (S) ; et
• lorsque l'écart entre le potentiel du noeud et le deuxième potentiel (Vss) atteint un seuil d'un troisième transistor MOS (M3), bloquer le premier transistor MOS (M1).

## Patentansprüche

1. Schaltung zum Erkennen eines potenzialfreien Zustands eines Knotens, umfassend:
• einen Knoten (N), der in Betrieb zum Aufweisen von zwei Arbeitszuständen angeschlossen ist, nämlich einem Zustand mit niedriger Impedanz, in dem er über einen Pfad mit niedriger Impedanz (S) mit einer ersten Versorgungsleitung (Vdd) verbunden ist, und einem potenzialfreien Zustand, in dem kein Element sein Potenzial festlegt;
• einen ersten MOS-Transistor (M1) einer ersten Leitfähigkeitsart, der zwischen dem Knoten (N) und einer zweiten Versorgungsleitung (Vss) verbunden ist; und
• einen zweiten MOS-Transistor (M2) einer Leitfähigkeitsart komplementär zu der ersten Leitfähigkeitsart, der durch den Knoten (N) gesteuert wird und zwischen dem Gate des ersten Transistors (M1) und der ersten Versorgungsleitung (Vdd) verbunden ist;
**dadurch gekennzeichnet, dass** sie einen dritten MOS-Transistor (M3) der ersten Leitfähigkeitsart umfasst, der durch den Knoten (N) gesteuert wird und zwischen dem Gate des ersten Transistors (M1) und der zweiten Versorgungsleitung (Vss) verbunden ist.

2. Schaltung nach Anspruch 1, wobei der erste und der zweite Transistor eine niedrigere Schwellenspannung (LVT) als der dritte Transistor aufweisen.

3. Schaltung nach Anspruch 1, umfassend einen mechanischen Schalter (S), der zwischen dem Knoten (N) und der ersten Versorgungsleitung (Vdd) verbunden ist.

4. Schaltung nach Anspruch 3, wobei der Knoten (N) mit einem Eingang einer Verarbeitungsschaltung (10) verbunden ist.

5. Verfahren zum Erkennen eines potenzialfreien Zustands eines Knotens, umfassend die folgenden Schritte:
• Verbinden des Knotens (N) über einen Pfad mit niedriger Impedanz (S) mit einem ersten Potenzial (Vdd);
• Trennen des Pfads mit niedriger Impedanz zum Platzieren des Knotens in einen potenzialfreien Zustand, in dem kein Element sein Potenzial festlegt;
• Entladen des Knotens in Richtung eines zweiten Potentials (Vss) durch einen Leckstrom von einem ersten MOS-Transistor (M1) in dem Sperrzustand; und
• wenn die Differenz zwischen dem Potenzial des Knotens und dem ersten Potenzial (Vdd) einen Schwellenwert eines zweiten MOS-Transistors (M2) erreicht, Leitendmachen des ersten MOS-Transistors.
**dadurch gekennzeichnet, dass** es die folgenden Schritte umfasst:
• wobei der Knoten (N) anfänglich auf dem zweiten Potenzial (Vss) ist, Ziehen des Knotens in Richtung des ersten Potenzials (Vdd) durch Schließen eines Unterbrechers (S); und
• wenn die Differenz zwischen dem Potenzial des Knotens und dem zweiten Potenzial (Vss) einen Schwellenwert eines dritten MOS-Transistors (M3) erreicht, Sperren des ersten MOS-Transistors (M1).

## Claims

1. A circuit for detecting a floating state of a node, comprising:
a node (N) connected, in operation, for having two operating states including a low impedance state where it is connected to a first power supply line (Vdd) through a low impedance path (S), and a floating state where no element establishes its voltage;
a first MOS transistor (M1) of a first conductivity type connected between the node (N) and a second supply line (Vss); and
a second MOS transistor (M2) of a conductivity type complementary to the first conductivity type, controlled by the node (N) and connected between the gate of the first transistor (M1) and the first supply line (Vdd);
wherein it comprises a third MOS transistor (M3) of the first conductivity type, controlled by the node (N) and connected between the gate of the first transistor (M1) and the second supply line (Vss).

2. The circuit of claim 1, wherein the first and second transistors have a lower threshold voltage (LVT) than the third transistor.

3. The circuit of claim 1, comprising a mechanical switch (S) connected between the node (N) and the first supply line (Vdd).

4. The circuit of claim 3, wherein the node (N) is connected to an input of a processing circuit (10).

5. A method of detecting a floating state of a node, comprising the steps of:
connecting the node (N) to a first voltage (Vdd) through a low impedance path (S);
interrupting the low impedance path to place the node in a floating state where no element establishes its potential;
discharging the node to a second voltage (Vss) by a leakage current of a first MOS transistor (M1) in the off state; and
when the difference between the voltage at the node and the first voltage (Vdd) reaches a threshold of a second MOS transistor (M2), turning on the first MOS transistor.
wherein it comprises the steps of:
the node (N) being initially at the second voltage (Vss), pulling the node towards the first voltage (Vdd) by closing a switch (S); and
when the difference between the voltage at the node and the second voltage (Vss) reaches a threshold of a third MOS transistor (M3), turning off the first MOS transistor (M1).
